# EUROPEAN PATENT SPECIFICATION

(11) **EP 3 310 984 B1**
(45) Date of publication and mention of the grant of the patent: **20.03.2019**
(21) Application number: 17746508.5
(22) Date of filing: 07.08.2017
(51) Int. Cl.: E05F 15/46, H03K 17/975, H03K 17/955

(54) **CAPACITIVE JAM PROTECTION**
CAPACITIVE JAM PROTECTION
PROTECTION CAPACITIVE CONTRE LE COINCEMENT

(30) Priority: 22.08.2016 EP 16185190
(43) Date of publication of application: 25.04.2018
(73) Proprietor: Captron Electronic GmbH, 82140 Olching (DE)
(72) Inventor: HÜTTENHOFER, Kilian, 81247 München (DE); BELLM, Reinhard, 82110 Germering (DE)
(74) Representative: Lohr, Jöstingmeier & Partner
(86) International application number: PCT/EP2017/069906
(87) International publication number: WO 2018/036794

(56) References cited:
- DE-A1-102014 216 249
- US-A1- 2008 211 519
- US-A1- 2010 060 471
- US-A1- 2010 117 785
- US-A1- 2011 128 018
- US-A1- 2015 070 033

## Description

### Field of the invention

The invention relates to a capacitive sensor system and to a capacitive jam protection for doors, preferably for doors of vehicles.

### Description of the related art

Automatically closing doors in accessible areas, like doors in trains, busses, all kinds of vehicles, elevators, or windows, car roofs or similar require monitoring of the closure area for persons or body parts to avoid jamming.

The German Patent DE 102 20 725 C1 discloses a device for jamming detection. A rubber seal at a window frame includes an electrical conductor for detecting changes in the electrical field, which may be caused by persons or body parts which have a moderate conductivity, and therefore easily influence electrical fields. Furthermore, an electrical shield is provided to reduce effects of the window on the electrical field of the conductor. This solution cannot be used for dual doors operating in opposite directions, as in a position where both doors are close to each other the electrical field of a signal line in the first door directly influences a signal line in the second door, and therefore makes the device insensitive for small changes which may be induced by a human body or body parts in the proximity of the doors.

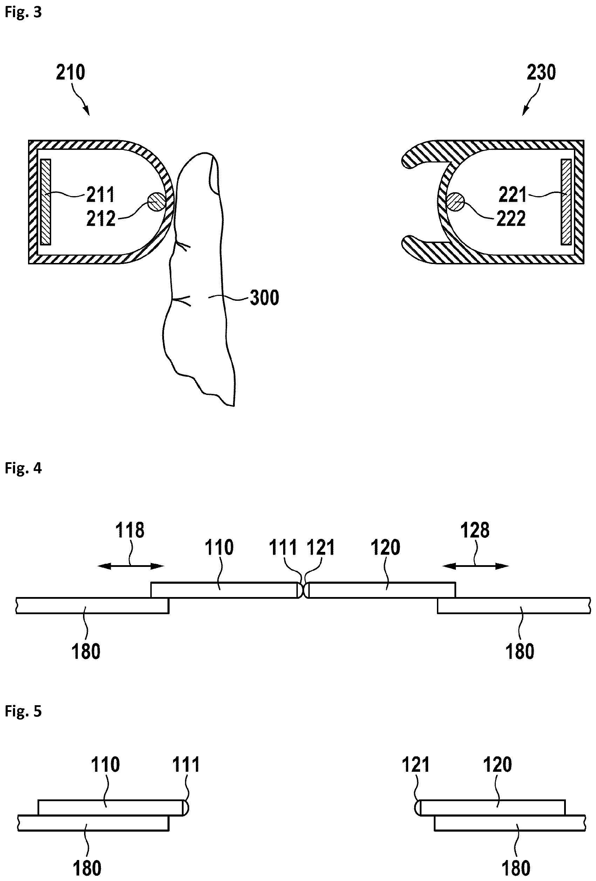

The German patent DE 10 2008 005783 B4 discloses a further capacitive jamming protection. Also here, a rubber seal includes a signal line together with a shield to reduce effects of the environment. When two opposing doors as shown in Figure 3 are used, the shields of the sealings are supplied with clock signals having a phase shift of 180 degrees. A sensing line in-between, integrated in one of the seals picks up the signals which are further amplified and rectified by a synchronous rectifier. The rectified signal is fed to a differential amplifier forming a control loop, and further controlling the amplitude of the clock signals, such that the sum signal at the sensing line equals to zero. When a body part approaches a sensing line, the control amplifier has to adapt the clock signals. Therefore, the control amplifier's output voltage is an indication of the object in the proximity of the sensing line. The problem arises, if both doors are close to each other. A small finger approaching one of the seals can hardly be detected, as the signal being coupled from the opposing door has a significantly larger effect than the small finger.

US 2010/0117785 A1 discloses an entrance barrier comprising a barrier element movable between and open and a closed position. The barrier elements have capacitive sensors which determine the frequency of oscillators which is further measured and evaluated.

US 2015/007033 A1 discloses a capacitive sensor for a vehicle. Thereby, a capacitive sensor is formed by a transmission electrode and a receiver electrode.

US 2008/0211519 A1 discloses a capacitive sensor which may also be used for vehicles. The sensor is integrated into an elastic housing and includes a plurality of sensor and shielding electrodes.

US 2010/0060471 A1 discloses a capacitive detection system to determine seat occupancy in a vehicle.

### Summary of the invention

The problem to be solved by the invention is to provide a capacitive jamming detection which may be used for an opening, preferably for doors, windows etc. and most preferably for dual section doors and which may be based on standard door sealing having one signal conductor and a shield, while achieving a higher sensitivity. Solutions of the problem are described in the independent claims. The dependent claims relate to further improvements of the invention. A first embodiment is based on a first sensor and an opposing second sensor movable relative to each other and defining an opening which may be opened or closed. Preferably, the first sensor is in a first door section and the second sensor is in a second door section. When closing the door, the first door section approaches the second door section and consequently the first sensor approaches the second sensor. Preferably, both doors sections are movable, but also the first section may be movable, whereas the second section the stationary or vice versa. In a closed state of the door, the sensors are close to each other, whereas in an open state of the door, they are distant from each other. Preferably, at least one the sensor is integrated into or at least connected to a door sealing, which may further provide a mechanical protection. It is further preferred, if the sensors comprise a soft and/or flexible sensor housing which may prevent damage of an object preferably having a certain conductivity or a person between the door sections when the door is closing or closed. In an alternate embodiment, the housing may be any material suitable for holding the components, preferably an insultiung material. Preferably, the sensors cover an edge and/or a narrow side of at least one door section. There may be a single sensor covering the whole action and/or a narrow side of the door section. Such a sensor may have a length between two and 2.5 m. Alternatively, there may be a plurality of shorter sensor sections, for example having a length between .3 and 1 m. Each sensor preferably comprises at least one reference conductor and at least one sensing line insulated and distant from the reference conductor. Preferably, the at least one reference conductor and the at least one sensing line are integrated into a common housing which preferably comprises a soft of flexible material like rubber or any other suitable polymer.

For detecting an object in between or in close proximity to the sensors and or the door section, at least two different measurements have to be made which are further designated as measurement mode A and measurement mode B. In a first measurement mode A, a measurement signal is applied to the reference conductor of the first sensor, while the reference conductor of the second sensor is without a signal, e.g. grounded. In the second measurement mode B, the reference conductor of the first sensor is without a signal, e.g. grounded, while the measurement signal is applied to the reference conductor of the second sensor. Switching between the measurement modes may be done by a switch unit which selects a connection between a sensor reference conductor and a signal generator providing the measurement signal or ground according to the selected measurement mode. The measurement signal may be an AC signal having a frequency between 10 kHz and 10 MHz and a signal amplitude between 100 mV and 20 V. In both modes, the signal of a sensing line in the first sensor is evaluated.

In mode A, part of the measurement signal applied to the reference conductor of the first sensor is coupled capacitive to the sensing line of the first sensor. There may be a further capacitive bypass by a an object close to the sensing line and/or the second sensor which may be close to the first sensor in a door closed state or distant from the first sensor in an door open state. Such capacitive bypasses further attenuate the signal at the sensing line.

In mode B, part of the measurement signal applied to the reference conductor of the second sensor is coupled capacitive to the sensing line of the first sensor. There may be a further capacitive bypass by a an object close to the sensing line and/or the first sensor which may be close to the second sensor in a door closed state or distant from the second sensor in an door open state. Such capacitive bypasses further attenuate the signal at the sensing line. Due to the large capacitance of the grounded reference conductor of the first sensor, an object close to the first sensor has a negligible effect.

Generally, the environment, like the doors, walls, holding the doors, or a floor are referenced to ground. In a vehicle like a bus, these components almost comprise metal and therefore provide a good ground which also may provide an attenuation on the measurement signal. In the case of metal doors or significant metal components within the doors, which are preferably electrically connected to ground, the measurements may also work, even if the reference conductor, into which no measurement signal is coupled, is not grounded. Furthermore, a person standing on a grounded floor or being close to a grounded door has sufficient capacitive coupling to ground to provide attenuation on the signal line when approaching a sensor.

To generate a signal indicating the presence of an object in proximity to the first sensor, the attenuations measured in mode A is correlated with the attenuations measured in mode B. This may for example be made by marking the attenuations in a two-dimensional diagram, for example, each measurement forming a point with mode B along the X axis and mode A along the Y axis. When no object is in proximity of the first sensor, the points of attenuation are on a first curve or fall into a certain area. When there is an object in close proximity to the first sensor, the points of correlation are on a second curve or area, distant from the first curve or area. Approximately, the distance of the curves varies with the distance of the object is to the first sensor line. This kind of correlation and/or evaluation may be done in an evaluation unit, which may be a microcontroller. An object presents signal may be generated if the correlated signals for into a predetermined area.

In this example, the measurement of mode B may also be used to estimate the distance between sensors and therefore between the door sections.

If the distance of an object with respect to the second sensor should be measured, application of a measurement signal and the sensing line is interchanged between the first and the second sensor.

In another embodiment, there may ba a further mode C, where both reference conductors are fed by the same signal. This mode may be used supplementary to and/or replacing Mode A.

In a further embodiment, there may be at least a further line approximately in parallel to a sensing line, most preferably in parallel to the first sensing line. The second line may be connected to the reference conductor of the same sensor and therefore perform a certain degree of shielding. If, for example there are two parallel lines at the top of the sensor, a first line may be used as a sensing line, whereas the second one may be connected to the reference conductor. Such incentives comparatively sensitive to approaching an object from the side of the sensing line, whereas it is insensitive to an approaching object from the side of the line used for shielding. There may also be a plurality of lines used for shielding to achieve complex sensitivity patterns.

Preferably, there are two identical sensors at the door section. This allows the same degree of object detection and protection at and of each of the door section. In a simplified embodiment, they may be a sensing line only at the first sensor. A sensing line at the second sensor is not necessary, if it is not desired to detect objects close to the second sensor.

In a further embodiment, approaching of an object in a closed state of the door may be detected as mentioned above. This may be used to generate a signal, for example to request opening of the door. Therefore, there is a second function of the device described above replacing a door opening request switch. Of course this sensor may trigger any other function.

A further embodiment relates to a wireless design. Basically, there are two sensors movable against each other. In specific embodiments, there may be one door or window which is movable or there may be two door sections moving against each other. Connecting movable parts by cables or wires is always error-prone. Therefore, it is preferred to have the communication between movable parts either capactive or by RF signal coupling. A preferred way of coupling may be NFC (Near Field Communication). Furthermore, it is preferred, if the movable parts have a battery or capacitor which is inductively charged in an idle position, which may be the closed position of a door.

Preferably, the signal generator unit comprises a first signal generator sub-unit, associated with the first sensor and a second signal generator sub-unit, associated with the second sensor. The sub-units are alternatingly providing signals to the sensors and are preferably syncronized by radio coupling signals.

It is further prfeerred, if the control circuit comprises a RF tranmitter to transmit the output signal to an extrenal controller, e.g. a controller of a vehicle, which further evaluates the door signals. Furthermore, the control circuit may comprise a battery or capacitor which is inductively charged in an idle position.

A further embodiment relates to a method of operating a sensor and a method of detecting the presence of an object as disclosed above.

### Description of Drawings

In the following the invention will be described by way of example, without limitation of the general inventive concept, on examples of embodiment with reference to the drawings.
Figure 1 shows a first embodiment.
Figure 2 shows another embodiment.
Figure 3 shows a further embodiment of sensors.
Figure 4 shows a common sliding door in a closed state.
Figure 5 shows the sliding door in an open state.
Figure 6 shows signals measured by the control circuit.
Figure 7 shows a position-independent signal.

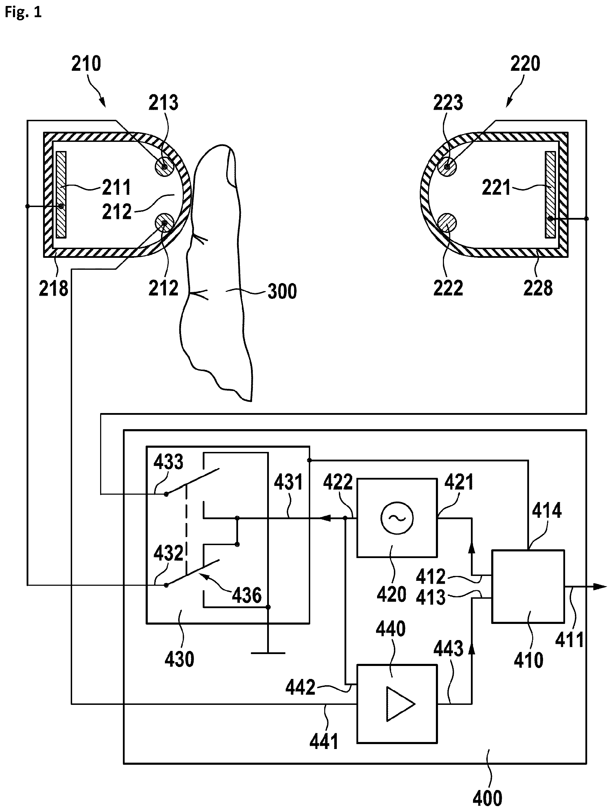

In Figure 1, a first embodiment is shown. A first sensor 210, second sensor 220, opposing each other and a control circuit 400 are provided for detecting an object 300, like a finger or any other body part of a person. Preferably, the sensors are at the inner sides of a door, preferably of a sliding door, and most preferably of an automatic sliding door.

Each sensor preferably comprises a reference conductor 211, 221, at least one sensing line 212, 213, 222, 223, and housing 218, 228. Preferably, the housing comprises a soft or flexible material like rubber or any other suitable polymer. The housing basically has two functions. The first function is to hold the sensing lines in a predetermined position with respect to the reference conductors. The second function is a mechanical function, such that the housing is compressed under high pressure, and therefore prevents damage of an object or a person between the door sections when the door is closing or closed.

The embodiment shown in this figure is for detecting an object 300 in close proximity to the first sensor 210. If an object in close proximity of the second sensor 220 has to be detected, the order of sensors may simply be reversed or exchanged, preferably in certain and/or predetermined measurement intervals. Therefore, the first sensor has the function of the second sensor and vice versa. This does not require changing the circuit. Instead, this may be done for example, by software, within the control circuit 400. The control circuit 400 preferably comprises a signal generator 420 (which is preferably reference to ground) to produce an output signal for driving at least one of the reference conductors and or of the sensing lines. Basically, there are two measurements modes, as will be explained later in more detail. In a first measurement mode A, a measurement signal is applied to the first sensor reference conductor, while the second sensor reference conductor is grounded. In the second measurement mode B, the first reference conductor is grounded, while the measurement signal is applied to the second reference conductor. Switching between the measurement modes is done by a switch unit 430 which selects a connection between a sensor reference conductor and a signal generator or ground according to the selected measurement mode.

The switch unit 430 preferably has at least two switches 436 which preferably are operated synchronously. The switches may be relays or solid-state switches. Preferably, there is a switch input which may be connected to a generator output 422 to receive a generator's signal. Furthermore, there are at least two outputs 432, 433 which may be connected to the sensors. Preferably the outputs are toggled between ground and the generator's signal. Therefore, for example for selecting mode A, the first switch output 432 is connected to the generator's signal, whereas the second switch output 433 is connected to ground. For selecting mode B, the connections of the outputs are reversed.

In this embodiment, the second sensing line 213 of the first sensor is connected in parallel with the first sensor reference conductor 211. This results in a certain direction sensitivity. The resulting sensitivity for detecting an object close to the first sensing line 212 is much higher than close to the second sensing line 213. Therefore, as shown in this Figure, a finger 300 approaching from the bottom side may be detected from a larger distance, whereas a finger being approached from the top side would hardly be detected. This allows a certain selectivity, for example in a bus where it may be desired only to detect an object approaching the door from the inside, but not from the outside of the bus or vice versa.

The signal which is fed into the reference conductors is capacitive coupled via the air gap between the reference conductors and a sensing line into the sensing lines. The signal is fed through signal input 441 from the outside into an amplifier 440 which may have a rectifier or preferably a synchronous rectifier which may be controlled by a signal received at a sync input 442 generated by the signal generator 420. The amplifier may further comprise certain high pass or low pass filters to select a desired signal. The signal at the output 443 of the amplifier 440 is fed via input 413 to an evaluation unit which may be a microcontroller 410, which controls at least parts of the control circuit 400. The microcontroller may further trigger or control via switch control line 414 the switch 430 and may further feed via generator control line 412 a control signal to the signal generator 420 via control input 412. It may further provide an output signal at output line 411 at least indicating whether an object is present or not. As will be shown later, the control circuit may even provide an indication about the distance of the object and/or the distance between the door sections.

For selecting the direction of main sensitivity, as described above, one of the sensing lines 212, 213 may be connected to the reference conductor 211. Alternatively, none of the sensing lines may be connected to the reference conductor, but both may be used to feed the amplifier 440. In a closed state of the door, where first sensor 210 and second sensor 220 are close to each other, objects close to the sensors may be detected.

Further, by evaluating the different signals from the different sensing lines and/or connecting at least one sensing line to a sensor reference conductor, it is also possible to detect from which side an object has approached the door. This may for example be used as a request switch for a person approaching a vehicle from the outside for opening the door. Therefore, an additional switch is no more necessary. As explained above, this switch may only be sensitive to an object approaching from the outside, but not from the inside. This may avoid erroneous triggering of the door open request signal. If, for example in the embodiment shown in this figure, the top side of the figure would be an inside of a vehicle and the bottom side would be an outside thereof, the sensors would be more sensitive to an object 300 (e.g. a finger) approaching from the bottom of the figure (outside) compared to an object approaching from the top of the figure (inside). This allows clearly distinguishing the approach side and therefore may be used as a switch for signaling for example a door open request.

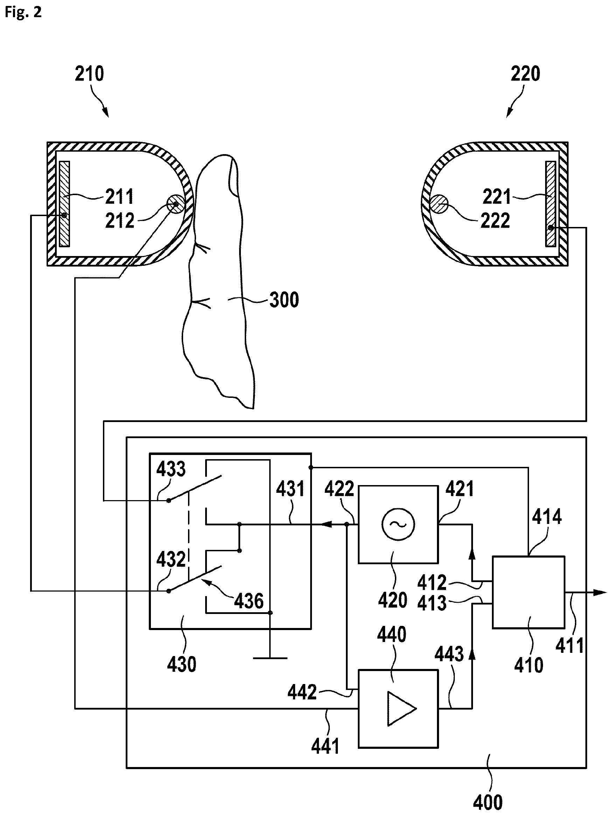

In Figure 2, a previous embodiment is shown. Here, the sensors comprise only a single sensing line, which simplifies the circuit but does not provide further selectivity of the object approaching from inside or outside of the door.

In Figure 3, a further embodiment of sensors is shown. Whereas the first sensor 210 is the same as previously described, the second sensor 230 may have a different shape, which allows a better sealing of the door, when the first sensor mates with the second sensor in a closed state of the door.

In Figure 4, a common sliding door in a closed state is shown in a top view, which may be used in buses or trains or other public transportation vehicles, or in elevators or buildings. This door may be a planar sliding door or a rotating door. A wall 180 may have an opening which may be closed by a door. There is a first sliding door section 110 which is movable into a first direction 118 of movement, and a second sliding door section 120 being movable in a second direction 128 opposing the first direction 118. Between the sliding doors at the inside of the opening are a first sensor 111 and a second sensor 121, as described above.

In Figure 5, the previous sliding door is shown in an open state.

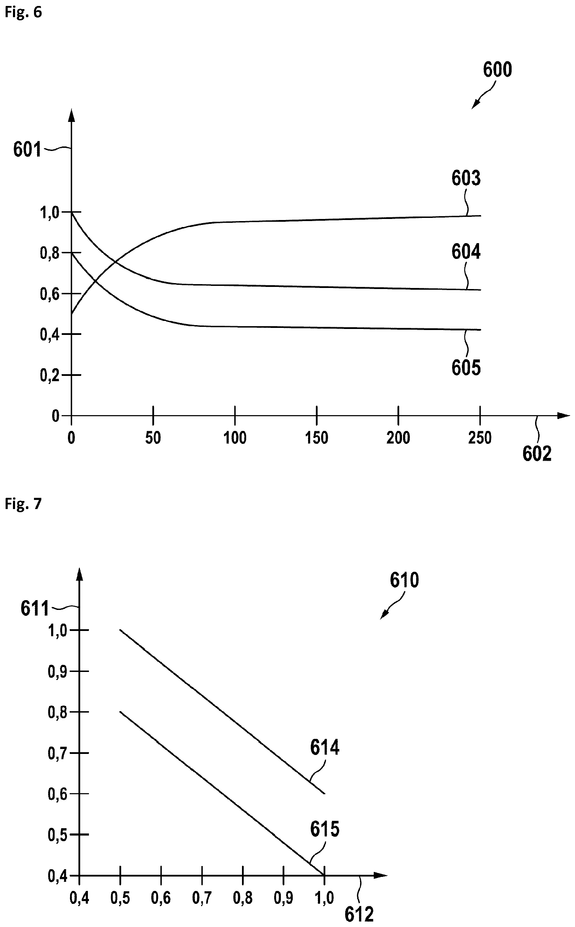

In Figure 6, signals as measured by the control circuit 400 are shown. A diagram 600 provides an x-axis 602 which shows an opening distance between two sections of a door, the scale may be calibrated in millimeters, whereas a y-axis 601 shows the relative signal attenuation. A value of 1 means a maximum attenuation, whereas 0 is no attenuation. In general, there is a certain attenuation due to the capacitive coupling between a reference conductor and a sensing line, such that a signal never would reach the 0 attenuation value. The first curve 603 shows the attenuation of a signal in mode B, where the reference conductor of the second sensor 220 as shown in Figure 1 is fed by a signal, while the reference conductor of the first sensor 210 is grounded. At a 0 distance, with the door closed, a signal is coupled from the reference conductor of the second sensor into the sensing line of the first sensor which a comparatively low attenuation of about 50 % in this example. When the door opens, the distance between the first sensor and the second sensor increases, and therefore the capacitive coupling gets weaker, and the attenuation increases.

The curves 604 and 605 show the attenuation in mode A, whereas curve 604 shows the state with an object like a finger being in close proximity to the sensing line of the first sensor, and the second curve 605 shows the attenuation without any object. In mode A, the reference conductor of the first sensor 210 as shown in Figure 1 is fed by a signal, while the reference conductor of the second sensor 220 is grounded When the door is closed, there is a comparatively high attenuation of the signal fed into the reference conductor of the first sensor 210, due to the grounded reference conductor of the second sensor 220 in a close distance. When the door opens, the coupling to the grounded reference conductor of the second sensor decreases, and therefore the attenuation of the signal further decreases. When an object is in close proximity to the sensing line of the first sensor, this further increases attenuation as shown in curve 604.

This diagram shows the difficulties in evaluating whether an object is in close proximity to the first sensor or not, at different openings of the door. For example, in a closed state of the door, the attenuation without any object (curve 605) is higher than the attenuation with an opening of 100 mm with an object (curve 604). Therefore, the approaching doors supersede the effect of an object like a person or a body part significantly.

In Figure 7, a position-independent signal is shown. Diagram 610 shows at its x-axis the attenuation of mode B, and at its y-axis the attenuation of mode A. For each point of curve 604 and 605 (mode B), the corresponding points measured at the same distance of door opening according to curve 603 (mode A) are entered into the diagram. The combination of curves 604 and 603 results in a curve 614, whereas curves 605 and 603 result in curve 615. As a result, there are two curves which are independent of the opening of the door. These curves are approximately linear or may at least be approximated by a linear curve. There is a significant measurement effect which allows easy distinguishing between the curves, and therefore concluding whether an object is close or not. Such an evaluation may be done by the microcontroller 410.

A further benefit is the measurement of mode B, which allows a rough estimate of the door opening distance, at least for small openings independent of if an object is in-between the door sections or not.

### List of reference numerals

- 110: first sliding door section
- 111: first sensor
- 118: first direction of movement
- 120: second sliding door section
- 121: second sensor
- 128: second direction of movement
- 180: wall
- 210: first sensor
- 211: sensor reference conductor
- 212: first sensing line
- 213: second sensing line
- 218: sensor housing
- 220: second sensor
- 221: sensor reference conductor
- 222: first sensing line
- 223: second sensing line
- 228: sensor housing
- 300: object
- 400: control circuit
- 410: microcontroller
- 411: output signal
- 412: generator control line
- 413: input
- 414: switch control line
- 420: signal generator
- 422: generator output
- 430: switch unit
- 431: switch input
- 432: first switch output
- 433: second switch output
- 436: switches
- 440: amplifier
- 441: signal input
- 442: sync input
- 443: amplifier output
- 480: wall
- 600: diagram
- 601: y-axis
- 602: x-axis
- 603: curve showing attenuation in mode B
- 604, 605: curve showing attenuation in mode A
- 614: combination of curves 604 and 603
- 615: combination of curves 605 and 603

## Claims

1. Device for detecting the presence of an object close to or within a space or an opening between a first sensor (210) and an opposing second sensor (220), movable against each other, the device comprising the first sensor (210) and the second sensor (220), the first sensor (210) comprising at least one reference conductor (211) and at least one sensing line (212) insulated and distant from the at least one reference conductor,
the second sensor (220) comprising at least one reference conductor (221), the at least one sensing line (212) of the first sensor (210) being arranged between the reference conductor (211) of the first sensor (210) and the reference conductor (221) of the second sensor (220),
the at least one sensing line (212) of the first sensor (210) being connected to an amplifier (440) generating an output signal indicating the signal strength and/or attenuation of a signal at the at least one sensing line (212),
a control circuit (400) being provided, the control circuit further comprising a signal generator unit (420, 430) having at least a first output (432) connected to the at least one reference conductor (211) of the first sensor (210) and a second output (433) connected to the at least one reference conductor (221) of the second sensor (220), whereas in a first measurement mode (A), the first output is configured to provide a signal and the second output is configured to provide no signal, and in a second measurement mode (B), the first output is configured to provide no signal and the second output is configured to provide a signal, and
the signal from the same sensing line (212) is used in the first measurement mode (A) and in the second measurement mode (B), and
an evaluation unit (410) is provided and is configured to determine a value of the output signal measured in the first measurement mode (A) and a value of the output signal (603) measured in the second measurement mode (B), wherein the evaluation unit (410) is configured to generate an object present signal (411) based on said values.

2. Device according to claim 1,
**characterized in, that**
the first sensor is attached to a first door section (110) and the second sensor is attached to a second door section (120), the first door section (110) and the second door section (120) defining a door opening.

3. Device according to claim 1 or 2,
**characterized in, that**
the signal generator unit comprising a signal generator (420) and a switch unit (430), the switch unit having at least a first output (432) and a second output (433), whereas in the first measurement mode (A), the first output is connected to the signal generator and the second output is connected to ground, and in the second measurement mode (B), the first output is connected to ground and the second output is connected to the signal generator.

4. Device according to claim 1,
**characterized in, that**
the object present signal is used as a door opening request signal.

5. Device according to any of the previous claims,
**characterized in, that**
at least one sensor comprises a soft and/or flexible housing.

6. Device according to any of the previous claims,
**characterized in, that**
at least one sensor comprises at least one further line, which may be connected to the reference conductor.

7. Device according to any of the previous claims,
**characterized in, that**
an evaluation unit (410) is configured to calculate a door opening distance estimate from the value of the output signal (603) measured in the second measurement mode (B).

8. Device according to any of the previous claims,
**characterized in, that**
the second sensor (220) comprising at least one sensing line (222) insulated and distant from the at least one reference conductor (221).

9. Device according to claim 8,
**characterized in, that**
the order of the first sensor and the second sensor is exchanged constantly or only in certain measurement intervals.

10. Device according to any of the previous claims,
**characterized in, that**
the signal generator unit comprises a first signal generator sub-unit, associated with the first sensor and a second signal generator sub-unit, associated with the second sensor, the sub-units are alternatingly providing signals to the sensors and are preferably synchronized by radio coupling signals.

11. Device according to any of the previous claims,
**characterized in, that**
the control circuit (400) comprises a RF transmitter to transmit the output signal (411) to controller and/or the control circuit (400) comprises a battery or capacitor which is inductively charged.

12. Method for operating a first sensor and a second sensor, opposing and movable against each other, each sensor comprising at least one reference conductor (211, 221) and at least one sensing line (212, 222) insulated and distant from the at least one reference conductor, the at least one sensing line (212) of the first sensor (210) being arranged between the reference conductor (211) of the first sensor (210) and the reference conductor (221) of the second sensor (220), by in a first measurement mode (A), feeding an AC signal into the reference conductor of the first sensor and generating by an amplifier (440) an output signal indicating the signal strength and/or attenuation of a signal at the at least one sensing line of the first sensor and in a second measurement mode (B), feeding an AC signal into the reference conductor of the second sensor and generating by an amplifier (440) the output signal indicating the signal strength and/or attenuation of the signal at the at least one sensing line of the first sensor, and by further determining a value of the output signal (604, 605) measured in the first measurement mode (A) and a value of the output signal (603) measured in the second measurement mode (B) and by the evaluation unit (410) generating an object present signal (411) based on said values.

## Patentansprüche

1. Vorrichtung zum Erfassen des Vorhandenseins eines Objekts in der Nähe oder innerhalb eines Raums oder einer Öffnung zwischen einem ersten Sensor (210) und einem gegenüberliegenden zweiten Sensor (220), wobei die Sensoren gegeneinander beweglich sind, wobei die Vorrichtung den ersten Sensor (210) und den zweiten Sensor (220) umfasst,
wobei der erste Sensor (210) mindestens einen Referenzleiter (211) und mindestens eine Abtastleitung (212), die isoliert und beabstandet von dem mindestens einen Referenzleiter ist, umfasst,
wobei der zweite Sensor (220) mindestens einen Referenzleiter (221) umfasst,
wobei die mindestens eine Abtastleitung (212) des ersten Sensors (210) zwischen dem Referenzleiter (211) des ersten Sensors (210) und dem Referenzleiter (221) des zweiten Sensors (220) angeordnet ist,
wobei die mindestens eine Abtastleitung (212) des ersten Sensors (210) mit einem Verstärker (440) verbunden ist, der ein Ausgangssignal erzeugt, das die Signalstärke und/oder -dämpfung eines Signals an der mindestens einen Abtastleitung (212) anzeigt, wobei eine Steuerschaltung (400) vorgesehen ist, wobei die Steuerschaltung weiterhin eine Signalerzeugungseinheit (420, 430)umfasst mit mindestens einem ersten Ausgang (432), der mit dem mindestens einen Referenzleiter (211) des ersten Sensors (210) verbunden ist, und einem zweiten Ausgang (433), der mit dem mindestens einen Referenzleiter (221) des zweiten Sensors (220) verbunden ist, wobei in einem ersten Messmodus (A) der erste Ausgang konfiguriert ist, um ein Signal zu liefern und der zweite Ausgang konfiguriert ist, um kein Signal liefern, und in einem zweiten Messmodus (B) der erste Ausgang konfiguriert ist, um kein Signal zu liefern und der zweite Ausgang konfiguriert ist, um ein Signal zu liefern, und
das Signal derselben Abtastleitung (212) im ersten Messmodus (A) und im zweiten Messmodus (B) verwendet wird, und
eine Auswertungseinheit (410) bereitstellt und konfiguriert ist, um einen Wert des im ersten Messmodus (A) gemessenen Ausgangssignals zu bestimmen und einen Wert des im zweiten Messmodus (B) gemessenen Ausgangssignals (603), wobei die Auswertungseinheit (410) konfiguriert ist, um basierend auf diesen Werten ein Objekt-vorhanden-Signal (411) zu erzeugen.

2. Vorrichtung nach Anspruch 1,
**dadurch gekennzeichnet, dass**
der erste Sensor an einem ersten Türabschnitt (110) und der zweite Sensor an einem zweiten Türabschnitt (120) angebracht ist, wobei der erste Türabschnitt (110) und der zweite Türabschnitt (120) eine Türöffnung definieren.

3. Vorrichtung nach Anspruch 1 oder 2,
**dadurch gekennzeichnet, dass**
die Signalerzeugungseinheit einen Signalerzeuger (420) und eine Schalteinheit (430) aufweist, wobei die Schalteinheit mindestens einen ersten Ausgang (432) und einen zweiten Ausgang (433) hat, wobei im ersten Messmodus (A) der erste Ausgang mit dem Signalerzeuger und der zweite Ausgang mit der Masse verbunden ist, und im zweiten Messmodus (B) der erste Ausgang mit der Masse und der zweite Ausgang mit dem Signalerzeuger verbunden ist.

4. Vorrichtung nach Anspruch 1,
**dadurch gekennzeichnet, dass**
das Objekt-vorhanden-Signal als ein Türöffnungsanfragesignal verwendet wird.

5. Vorrichtung nach einem der vorhergehenden Ansprüche,
**dadurch gekennzeichnet, dass**
mindestens ein Sensor ein weiches und/oder flexibles Gehäuse aufweist.

6. Vorrichtung nach einem der vorhergehenden Ansprüche,
**dadurch gekennzeichnet, dass**
mindestens ein Sensor mindestens eine weitere Leitung umfasst, die mit dem Referenzleiter verbunden werden kann.

7. Vorrichtung nach einem der vorhergehenden Ansprüche,
**dadurch gekennzeichnet, dass**
eine Auswertungseinheit (410) konfiguriert ist, um eine Schätzung eines Türöffnungsabstandes aus dem Wert des Ausgangssignals (603), der in dem zweiten Messmodus (B) gemessen wurde, zu berechnen.

8. Vorrichtung nach einem der vorhergehenden Ansprüche,
**dadurch gekennzeichnet, dass**
der zweite Sensor (220) mindestens eine Abtastleitung (222) umfasst, die isoliert und beabstandet von dem mindestens einen Referenzleiter (221) ist.

9. Vorrichtung nach Anspruch 8,
**dadurch gekennzeichnet, dass**
die Reihenfolge des ersten Sensors und des zweiten Sensors dauerhaft getauscht wird oder nur in bestimmten Messintervallen getauscht wird.

10. Vorrichtung nach einem der vorhergehenden Ansprüche,
**dadurch gekennzeichnet, dass**
die Signalerzeugungseinheit eine erste Signalerzeugungsuntereinheit umfasst, die dem ersten Sensor zugeordnet ist, und eine zweite Signalerzeugungsuntereinheit umfasst, die dem zweiten Sensor zugeordnet ist, wobei die Untereinheiten abwechselnd Signale an die Sensoren liefern und vorzugsweise durch Funkwellenkopplungssignale synchronisiert sind.

11. Vorrichtung nach einem der vorhergehenden Ansprüche,
**dadurch gekennzeichnet, dass**
die Steuerschaltung (400) einen HF-Sender zum Senden des Ausgangssignals (411) an die Steuerung umfasst, und/oder die Steuerschaltung (400) eine Batterie oder einen induktiv geladenen Kondensator umfasst.

12. Verfahren zum Betreiben eines ersten Sensors und eines zweiten Sensors, welche einander gegenüberliegend und gegeneinander beweglich sind, wobei jeder Sensor mindestens einen Referenzleiter (211, 221) und mindestens eine Abtastleitung (212, 222), die isoliert und beabstandet von dem mindestens einen Referenzleiter ist, umfasst, wobei die mindestens eine Abtastleitung (212) des ersten Sensors (210) zwischen dem Referenzleiter (211) des ersten Sensors (210) und dem Referenzleiter (221) des zweiten Sensors (220) angeordnet ist, durch
in einem ersten Messmodus (A) Einspeisen eines Wechselstromsignals in den Referenzleiter des ersten Sensors und Erzeugen eines Ausgangssignals durch einen Verstärker (440), welches eine Signalstärke und/oder -dämpfung eines Signals an der mindestens einen Abtastleitung des ersten Sensors anzeigt, und
in einem zweiten Messmodus (B) Einspeisen eines Wechselstromsignals in den Referenzleiter des zweiten Sensors und Erzeugen eines Ausgangssignals durch einen Verstärker (440), welches eine Signalstärke und/oder -dämpfung eines Signals an der zumindest einen Abtastleitung des ersten Sensors anzeigt,
und durch weiterhin
Bestimmen eines Wertes des im ersten Messmodus (A) gemessenen Ausgangssignals (604, 605) und eines Wertes des im zweiten Messmodus (B) gemessenen Ausgangssignals (603), und
basierend auf diesen Werten Erzeugen eines Objekt-vorhanden-Signals (411) durch die Auswertungseinheit (410).

## Revendications

1. Dispositif de détection de la présence d'un objet proche de ou au sein d'un espace ou d'une ouverture entre un premier capteur (210) et un second capteur opposé (220), mobiles l'un contre l'autre, le dispositif comprenant le premier capteur (210) et le second capteur (220),
le premier capteur (210) comprenant au moins un conducteur de référence (211) et au moins une ligne de détection (212) isolée et distante de l'au moins un conducteur de référence,
le second capteur (220) comprenant au moins un conducteur de référence (221), l'au moins une ligne de détection (212) du premier capteur (210) étant agencée entre le conducteur de référence (211) du premier capteur (210) et le conducteur de référence (221) du second capteur (220),
l'au moins une ligne de détection (212) du premier capteur (210) étant connectée à un amplificateur (440) générant un signal de sortie indiquant l'intensité de signal et/ou l'atténuation d'un signal au niveau de l'au moins une ligne de détection (212),
un circuit de commande (400) étant prévu, le circuit de commande comprenant en outre une unité de générateur de signal (420, 430) ayant au moins une première sortie (432) connectée à l'au moins un conducteur de référence (211) du premier capteur (210) et une seconde sortie (433) connectée à l'au moins un conducteur de référence (221) du second capteur (220), tandis que dans un premier mode de mesure (A), la première sortie est configurée pour fournir un signal et la seconde sortie est configurée pour ne fournir aucun signal, et dans un second mode de mesure (B), la première sortie est configurée pour ne fournir aucun signal, et la seconde sortie est configurée pour fournir un signal, et
le signal provenant de la même ligne de détection (212) est utilisé dans le premier mode de mesure (A) et dans le second mode de mesure (B), et
une unité d'évaluation (410) est prévue et est configurée pour déterminer une valeur du signal de sortie mesurée dans le premier mode de mesure (A) et une valeur du signal de sortie (603) mesurée dans le second mode de mesure (B), dans lequel l'unité d'évaluation (410) est configurée pour générer un signal d'objet-présent (411) d'après lesdites valeurs.

2. Dispositif selon la revendication 1,
**caractérisé en ce que**
le premier capteur est fixé à une première section de porte (110) et le second capteur est fixé à une seconde section de porte (120), la première section de porte (110) et la seconde section de porte (120) définissant une ouverture de porte.

3. Dispositif selon la revendication 1 ou 2,
**caractérisé en ce que**
l'unité de générateur de signal comprenant un générateur de signal (420) et une unité de commutateur (430), l'unité de commutateur ayant au moins une première sortie (432) et une seconde sortie (433), tandis que dans le premier mode de mesure (A), la première sortie est connectée au générateur de signal et la seconde sortie est connectée à la masse, et dans le second mode de mesure (B), la première sortie est connectée à la masse et la seconde sortie est connectée au générateur de signal.

4. Dispositif selon la revendication 1,
**caractérisé en ce que**
le signal d'objet-présent est utilisé comme signal de demande d'ouverture de porte.

5. Dispositif selon l'une quelconque des revendications précédentes,
**caractérisé en ce que**
au moins un capteur comprend un logement souple et/ou flexible.

6. Dispositif selon l'une quelconque des revendications précédentes,
**caractérisé en ce que**
au moins un capteur comprend au moins une ligne supplémentaire, qui peut être connectée au conducteur de référence.

7. Dispositif selon l'une quelconque des revendications précédentes,
**caractérisé en ce que**
une unité d'évaluation (410) est configurée pour calculer une estimation de distance d'ouverture de porte à partir de la valeur du signal de sortie (603) mesurée dans le second mode de mesure (B).

8. Dispositif selon l'une quelconque des revendications précédentes,
**caractérisé en ce que**
le second capteur (220) comprenant au moins une ligne de détection (222) isolée et distante de l'au moins un conducteur de référence (221).

9. Dispositif selon la revendication 8,
**caractérisé en ce que**
l'ordre du premier capteur et du second capteur est échangé constamment ou uniquement dans certains intervalles de mesure.

10. Dispositif selon l'une quelconque des revendications précédentes,
**caractérisé en ce que**
l'unité de générateur de signal comprend une première sous-unité de générateur de signal, associée au premier capteur et une seconde sous-unité de générateur de signal, associée au second capteur, les sous-unités fournissant en alternance des signaux aux capteurs et sont de préférence synchronisées par des signaux de couplage radio.

11. Dispositif selon l'une quelconque des revendications précédentes,
**caractérisé en ce que**
le circuit de commande (400) comprend un émetteur RF pour émettre le signal de sortie (411) à destination d'une unité de commande et/ou le circuit de commande (400) comprend une batterie ou un condensateur qui est chargé par induction.

12. Procédé d'exploitation d'un premier capteur et d'un second capteur, opposés et mobiles l'un contre l'autre, chaque capteur comprenant au moins un conducteur de référence (211, 221) et au moins une ligne de détection (212, 222) isolée et distante de l'au moins un conducteur de référence, l'au moins une ligne de détection (212) du premier capteur (210) étant agencée entre le conducteur de référence (211) du premier capteur (210) et le conducteur de référence (221) du second capteur (220), par dans un premier mode de mesure (A),
la fourniture d'un signal alternatif dans le conducteur de référence du premier capteur et la génération par un amplificateur (440) d'un signal de sortie indiquant l'intensité de signal et/ou l'atténuation d'un signal au niveau de l'au moins une ligne de détection du premier capteur et dans un second mode de mesure (B),
la fourniture d'un signal alternatif dans le conducteur de référence du second capteur et la génération par un amplificateur (440) du signal de sortie indiquant l'intensité de signal et/ou l'atténuation du signal au niveau de l'au moins une ligne de détection du premier capteur, et par en outre la détermination d'une valeur du signal de sortie (604, 605) mesurée dans le premier mode de mesure (A) et d'une valeur du signal de sortie (603) mesurée dans le second mode de mesure (B) et par l'unité d'évaluation (410) générant un signal d'objet-présent (411) d'après lesdites valeurs.
